(19)

Europäisches
Patentamt

European
Patent Office

Office européen
des brevets

(11) **EP 4 455 697 B1**

(12) **EUROPEAN PATENT SPECIFICATION**

(45) Date of publication and mention
of the grant of the patent:
**11.03.2026 Bulletin 2026/11**

(21) Application number: **22909838.9**

(22) Date of filing: **14.12.2022**

(51) International Patent Classification (IPC):
*G01R 31/387* (2019.01)     *G01R 31/374* (2019.01)
*G01R 31/367* (2019.01)

(52) Cooperative Patent Classification (CPC):
**G01R 31/387; G01R 31/367; G01R 31/374**

(86) International application number:
**PCT/CN2022/138943**

(87) International publication number:
**WO 2023/116524 (29.06.2023 Gazette 2023/26)**

(54) **BATTERY SOC ESTIMATION METHOD AND RELATED APPARATUS**

VERFAHREN ZUR SCHÄTZUNG DES BATTERIE-SOC UND ZUGEHÖRIGE VORRICHTUNG

PROCÉDÉ D'ESTIMATION D'UN ÉTAT DE CHARGE (SOC) DE BATTERIE ET APPAREIL ASSOCIÉ

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority:   **24.12.2021   CN 202111602390**

(43) Date of publication of application:
**30.10.2024   Bulletin 2024/44**

(73) Proprietor: **Great Wall Motor Company Limited
Baoding, Hebei 071000 (CN)**

(72) Inventors:
• **ZHANG, Junwei
Baoding, Hebei 071000 (CN)**

• **KANG, Wenrong
Baoding, Hebei 071000 (CN)**

(74) Representative: **Klunker IP
Patentanwälte PartG mbB
Destouchesstraße 68
80796 München (DE)**

(56) References cited:
| | |
|---|---|
| CN-A- 106 597 307 | CN-A- 106 646 265 |
| CN-A- 108 037 460 | CN-A- 112 034 369 |
| CN-A- 112 986 842 | CN-A- 113 514 770 |
| CN-A- 113 514 770 | CN-A- 115 113 070 |
| JP-A- 2006 267 014 | US-A1- 2012 310 563 |
| US-A1- 2021 263 107 | |

EP 4 455 697 B1

Description

## TECHNICAL FIELD

The present invention relates to the field of battery technology, and in particular to a method for estimating a state of charge (SOC) of a battery and related piece of electronic equipment, computer-readable storage medium, and vehicle.

## BACKGROUND

In battery management systems, SOC (state of charge) is a very important battery parameter. SOC represents a percentage of the remaining charge of a battery pack and is used to measure the remaining available capacity of the battery pack. Accurate SOC estimation can ensure the rationality of relevant strategies of a vehicle, the safety of the battery, and can optimize a driving experience of a driver and passengers.

At present, a general method for correction of SOC includes a static OCV (open circuit voltage) correction. This method uses an OCV-SOC table to calculate a current SOC of the battery. Therefore, for this method, the OCV-SOC table is one of the important battery cell parameters that the SOC calculation depends on. In order to obtain the OCV-SOC table, the battery cell needs to be tested to obtain the OCV-SOC table with respect to different temperatures and different discharge rates. However, the above tests take a long time, and usually manufacturers only provide OCV-SOC tables corresponding to several representative temperatures. Thus, during actual applications, the current temperature often does not match the temperatures corresponding to the OCV-SOC table, which leads to the problem of low SOC correction accuracy.

CN 113 514 770 A discloses a lithium battery residual capacity SOC prediction algorithm driven based on OCV and battery temperature driving, and the algorithm comprises the steps: collecting discharge parameters in a lithium battery discharge process according to frequency, and building a battery residual capacity model based on an ampere-hour method, wherein the discharge parameters comprise discharge current, OCV, battery temperature and discharge time; and performing linear fitting on the estimated residual capacity of the battery and the OCV to obtain a mathematical relationship between the OCV and the residual capacity SOC of the battery, and further obtaining a predicted value of the real-time residual capacity of the battery.

## SUMMARY

### Technical Problem

It is an object of the present invention to provide a method for estimating an SOC of a battery and a related electronic equipment, computer-readable storage medium, and vehicle, to solve the problem of low SOC correction accuracy caused by the temperature corresponding to the OCV-SOC table not matching actual temperature.

### Technical Solutions

The object is achieved with the features of independent claim 1 regarding the method, with the features of independent claim 10 regarding the piece of electronic equipment, with the features of claim 12 regarding the computer-readable storage medium, and with the features of claim 13 regarding the vehicle. Further embodiments are defined in the dependent claims.

### Beneficial Effects

The present invention provides a method for estimating an SOC of a battery, in the method, an SOC estimation value of the battery at a current moment is obtained first. Then, an open circuit voltage of the battery at the current moment and a maximum available capacity of the battery at the current temperature are obtained; and according to the maximum available capacity at the current temperature, the open circuit voltage at the current moment and a capacity-voltage fitting formula, an SOC target value corresponding to the battery at the current moment is obtained, where the capacity-voltage fitting formula is a formula obtained by fitting a remaining available capacity and a corresponding open circuit voltage at a preset temperature, and the remaining available capacity is obtained by multiplying a maximum available capacity and an SOC value at the preset temperature. Finally, the SOC target value at the current moment is used to correct the SOC estimation value of the battery at the current moment. The preset temperature may be the temperature corresponding to the OCV-SOC table given by a manufacturer. That is, through the above solution, the present invention can obtain the capacity-voltage fitting formula that is applicable to the current temperature by means of an existing OCV-SOC table, and then obtain the SOC target value at the current temperature, thereby the accuracy of the battery's SOC correction is improved.

**BRIEF DESCRIPTION OF THE DRAWINGS**

In order to illustrate the technical solutions of the present invention more clearly, the drawings that need to be used in the description of the invention or exemplary technologies will be briefly introduced below.

FIG. 1 is an implementation flowchart of a method for estimating an SOC of a battery;
FIG. 2 is a curve diagram of a preset capacity-temperature table;
FIG. 3 is a schematic diagram of an OCV-SOC curve at different temperatures;
FIG. 4 is a schematic diagram of a structural composition of a device for estimation of an SOC of a battery; and
FIG. 5 is a schematic diagram of a structural composition of a piece of electronic equipment.

**DETAILED DESCRIPTION OF THE EMBODIMENTS**

In the following description, for the purpose of explanation rather than limitation, specific details such as specific system structures and technologies are presented so as to thoroughly understand the present invention. However, it should be clear to persons skilled in the art that the present invention as defined in the claims may also be implemented in other ways without these specific details. In other cases, detailed descriptions of well-known systems, devices, circuits and methods are omitted to avoid unnecessary details hindering the description of the present invention.

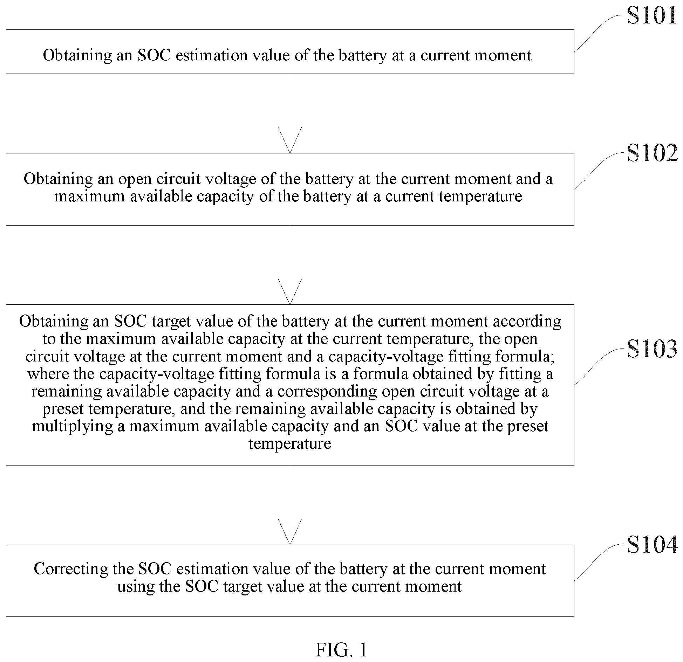

Referring to FIG. 1, which shows an implementation flowchart of a method for estimating an SOC of a battery. The method for estimating the SOC of the battery includes four steps from S101 to S104. The detailed description of the four steps is as follows.

In step S101: an SOC estimation value of the battery at a current moment is obtained.

An execution subject (electronic equipment) of this step may be a battery management system. In this step, the SOC estimation value of the battery may be obtained through a calculation based on an ampere-hour integration method. The SOC estimation value of the battery may also be obtained based on other calculation methods, which is not limited in here.

In step S102, an open circuit voltage (OCV) of the battery at the current moment and a maximum available capacity of the battery at a current temperature are obtained.

In this step, the open circuit voltage is a terminal voltage of the battery in an open circuit state. The polarization phenomenon will occur after the battery is charged or discharged, at this time, an external characteristic voltage of the battery is inconsistent with the open circuit voltage of the battery. Thus, before obtaining the open circuit voltage of the battery, the battery needs to be left to stand for a certain period of time to eliminate polarization. The voltage after standing is the terminal voltage of the battery in the open circuit state. The maximum available capacity refers to all capacity that is available when a fully-charged battery is discharged at a preset discharge rate (i.e., preset current intensity) at a certain temperature. In accordance with the physical properties of the battery, the maximum available capacity will vary according to the temperature of the battery. When the temperature is high, the maximum available capacity of the battery is large; when the temperature is low, the maximum available capacity of the battery is small.

In step S103: an SOC target value of the battery at the current moment is obtained according to the maximum available capacity at the current temperature, the open circuit voltage at the current moment and a capacity-voltage fitting formula. In here, the capacity-voltage fitting formula is a formula obtained by fitting a remaining available capacity and a corresponding open circuit voltage at a preset temperature, and the remaining available capacity is obtained by multiplying a maximum available capacity and an SOC value at the preset temperature.

The battery management system will calculate and update the battery's SOC estimation value in real time during a battery operation process. The SOC estimation value has errors which need to be corrected by the battery management system from time to time. For the existing static OCV correction method, the battery needs to be left to stand for a period of time before an accurate open circuit voltage can be detected. The battery in working condition for a long time is unable to realize the static and SOC estimation correction, so the error of SOC estimation value of the battery will become larger and larger due to accumulation.

In the existing technologies, to solve the above problem, the voltage and current during operation of the battery are usually measured; then, the open circuit voltage $U_{ocv}$ corresponding to a current measurement current and a current measurement voltage is calculated by combining a DC internal resistance DCR; finally, the SOC value corresponding to the current open circuit voltage $U_{ocv}$ is determined by looking up the table, thereby the SOC correction during the operation of the battery is realized.

However, when the battery leaves the factory, the OCV-SOC table provided by the supplier only corresponds to a few temperatures, for example, a OCV-SOC table corresponding to the normal temperature condition of 25°C. When the actual temperature does not match the temperatures corresponding to the OCV-SOC tables given by the supplier, resulting in the problem of low accuracy of SOC estimation.

In step S103, the OCV-SOC table corresponding to the known temperature is converted into a corresponding relation between the remaining available capacity and the open circuit voltage, so that the remaining available capacity corresponding to the open circuit voltage at the current moment can be calculated through the correspondence (the remaining available capacity corresponds to the above known temperature). Then, according to the remaining available capacity and the maximum available capacity at the current temperature, the SOC value corresponding to the current temperature is obtained. It can be seen that through step S103, the calculation of SOC at the current temperature can be realized without knowing the OCV-SOC table corresponding to the current temperature, thereby, not only can the tedious measurement work of the OCV-SOC table at all temperatures be avoided but also the calculation accuracy of SOC be improved.

In step S104, the SOC target value at the current moment is used to correct the SOC estimation value of the battery at the current moment.

After obtaining the SOC target value at the current moment in step S103, the SOC target value is used in the step S104 to replace the SOC estimation value at the current moment, to complete the SOC estimation of the battery at the current moment.

In a possible implementation, a specific implementation process of step S102 includes steps of:

obtaining a measurement voltage and a measurement current of the battery at the current moment; and
calculating, according to a formula $U_{ocv} = U_c + i \cdot DCR$, the open circuit voltage of the battery at the current moment; where $U_{ocv}$ represents the open circuit voltage, $U_c$ represents the measurement voltage, i represents the measurement current, and DCR represents a DC internal resistance of the battery.

In a possible implementation, a specific implementation process of step S102 also includes steps of:

obtaining the current temperature of the battery; and
looking up the maximum available capacity of the battery at the current temperature based on a preset capacity-temperature table.

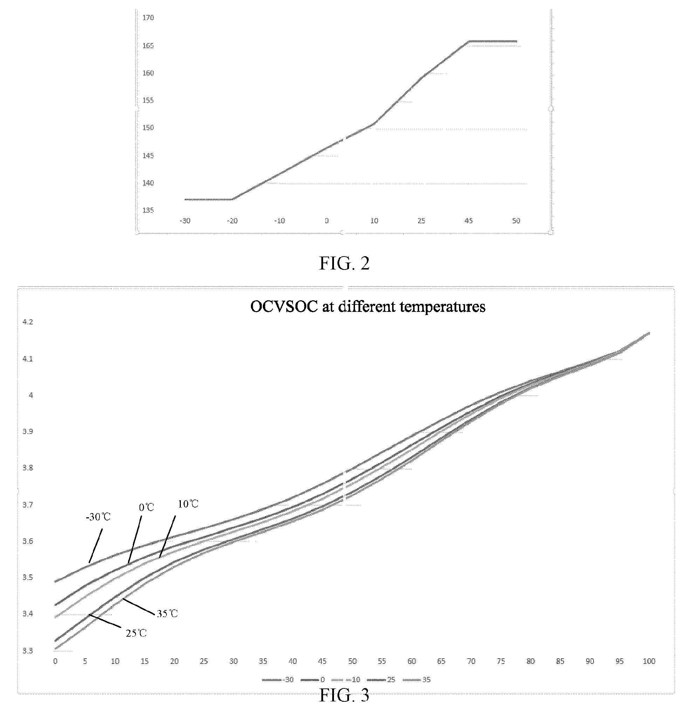

In this implementation, the preset capacity-temperature table includes a corresponding relation between the maximum available capacity and the temperature. FIG. 2 shows a curve corresponding to the preset capacity-temperature table. In FIG. 2, the horizontal coordinate is temperature and the vertical coordinate is maximum available capacity.

In a possible implementation, a process of obtaining the capacity-voltage fitting formula based on a fitting of the remaining available capacity and the corresponding open circuit voltage, in step S103, includes steps of:

obtaining the preset OCV-SOC table, where the preset OCV-SOC table includes multiple open circuit voltage versus SOC value data pairs at a preset temperature;
obtaining the maximum available capacity of the battery at the preset temperature;
multiplying all SOC values in the multiple open circuit voltage versus SOC value data pairs by the maximum available capacity at the preset temperature respectively, to obtain multiple remaining available capacities at the preset temperature; and
performing polynomial fitting with an independent variable being the remaining available capacity and a dependent variable being the open circuit voltage based on all open circuit voltages in the multiple open circuit voltage versus SOC value data pairs at the preset temperature and the multiple remaining available capacities, to obtain the capacity-voltage fitting formula.

In this implementation, the preset temperature may be 25 degrees Celsius. Generally, the maximum available capacity corresponding to 25 degrees Celsius is the rated capacity of the battery. Table 1 shows an OCV-SOC table at the preset temperature. As shown in Table 1, the preset OCV-SOC table includes open circuit voltages $U_{ocv}$ corresponding to multiple SOCs within a full range of SOC (0-100%). Each open circuit voltage corresponds to an SOC value, forming an open circuit voltage versus SOC value data pair. For example, when the open circuit voltage $U_{ocv}$ is 3.50, the SOC value is 15, then 3.50 and 15 form an open circuit voltage versus SOC value data pair.

Table 1

| SO C | 0 | 5 | 10 | 15 | 20 | 25 | 30 | 35 | 40 | 45 | 50 | ... | 95 | 100 |
|------|---|---|----|----|----|----|----|----|----|----|----|-----|----|-----|
| $U_{oc}$ | 3.3 | 3.3 | 3.4 | 3.5 | 3.5 | 3.5 | 3.6 | 3.6 | 3.6 | 3.6 | 3.7 | ... | 4.1 | 4.1 |
| v | 2 | 8 | 4 | 0 | 4 | 7 | 0 | 3 | 6 | 9 | 3 | | 1 | 7 |

Based on Table 1, the capacity-voltage fitting formula may be obtained by polynomial fitting, as shown in formula (1):

$$\begin{cases} Y = F(X) = K_0 \cdot X^0 + K_1 \cdot X^1 + K_2 \cdot X^2 + \cdots + K_n \cdot X^n \\ X = SOC \cdot C_{temp} \end{cases}$$

$$(1)$$

In the formula, $Y$ represents the open circuit voltage, $X$ represents the remaining available capacity at the current temperature (here is the temperature corresponding to Table 1, i.e., 25 degrees Celsius), $K_0 \sim K_n$ represent fitting coefficients of each fraction, and $C_{temp}$ represents the maximum available capacity at the current temperature (here is the temperature corresponding to Table 1, i.e., 25 degrees Celsius). As an example of this implementation, when fitting the data in Table 1, n = 6 is set, then the following may be obtained:

$K_6$ = 5.334e-25; $K_5$ = -2.772e-20; $K_4$ = 5.106e-16; $K_3$ = -3.787e-12;
$K_2$ = 7.498e-09; $K_1$ = 6.16e-05; and $K_0$ = 3.329.

In a possible implementation, the specific implementation process of step S103 in FIG. 1 includes a step of: inputting the maximum available capacity at the current temperature and the open circuit voltage at the current moment into the capacity-voltage fitting formula, to obtain the SOC target value corresponding to the battery at the current moment.

In this implementation, the SOC target value is calculated using formula (1). In formula (1), the fitting coefficients of each fraction (i.e., $K_0 \sim K_n$) are obtained based on a temperature (e.g., 25 degrees Celsius corresponding to Table 1), while these fitting coefficients can also be suitable to other temperatures. In other words, in this implementation, $K_0 \sim K_n$ in formula (1) can be used to solve the SOC target value. For formula (1), in this implementation, the maximum available capacity at the current temperature (i.e., $C_{temp}$) is known, the open circuit voltage at the current moment (i.e., $Y$) is known, and $K_0 \sim K_n$ are known; then SOC becomes the only unknown quantity, so the SOC value can be solved by formula (1).

In a possible implementation, the step S103 in FIG. 1 may also be implemented by the following steps:

determining remaining available capacities of the battery at multiple open circuit voltages according to the capacity-voltage fitting formula;
dividing each of the remaining available capacities by the maximum available capacity at the current temperature, to obtain SOC values at the current temperature;
determining the OCV-SOC table at the current temperature based on the SOC values at the current temperature and the corresponding open circuit voltages; and
looking up, in the OCV-SOC table at the current temperature, the SOC value corresponding to the open circuit voltage at the current moment, and taking the SOC value as the SOC target value of the battery at the current moment.

As described in the previous implementation, the fitting coefficients (i.e., $K_0 \sim K_n$) of each fraction in the capacity-voltage fitting formula (1) though are obtained based on one temperature (e.g., 25 degrees Celsius corresponding to Table 1), these fitting coefficients can also be suitable to other temperatures. In this implementation, the remaining available capacity corresponding to multiple open circuit voltages at the current temperature can be solved using $K_0 \sim K_n$.

Particularly, the maximum available capacity at the current temperature may be found through the capacity-temperature table shown in FIG. 2. In FIG. 2, the horizontal coordinate is temperature and the vertical coordinate is maximum available capacity. In fact, the OCV-SOC table at other temperatures (the OCV-SOC table at different temperatures is shown in FIG. 3) may be determined according to the capacity-voltage fitting formula at the preset temperature and the preset capacity-temperature table; and then the required SOC target value at the current moment can be queried according to the open circuit voltage at the current moment and the OCV-SOC table corresponding to the current temperature.

From the above description, it can be seen that, in the method for estimating the SOC of the battery the SOC target value at the current temperature can be obtained through the following steps: firstly, obtaining an SOC estimation value of the battery at a current moment; then, obtaining an open circuit voltage of the battery at the current moment and a maximum available capacity of the battery at a current temperature; and obtaining an SOC target value corresponding to the battery at the current moment according to the maximum available capacity at the current temperature, the open circuit voltage at the current moment and a capacity-voltage fitting formula; where, the capacity-voltage fitting formula is a formula obtained by fitting a remaining available capacity and a corresponding open circuit voltage at a preset temperature, and the remaining available capacity is obtained by multiplying a maximum available capacity and an SOC value at the preset temperature; and finally, using the SOC target value at the current moment to correct the SOC estimation value of the battery at the current moment. The preset temperature may be the temperature corresponding to the OCV-SOC table given by the manufacturer. That is, through the above steps, the capacity-voltage fitting formula can be obtained that is applicable to the current temperature by means of the existing OCV-SOC table, and then obtain the SOC target value at the current temperature, thereby the accuracy of the battery's SOC correction is improved.

It should be understood that the sequence number of the steps above does not mean the order of execution. The execution order of each process should be determined by its function and internal logic, and should not constitute any limitation on the implementation process.

The following is a corresponding device. For details not described in detail, references may be made to the corresponding method above.

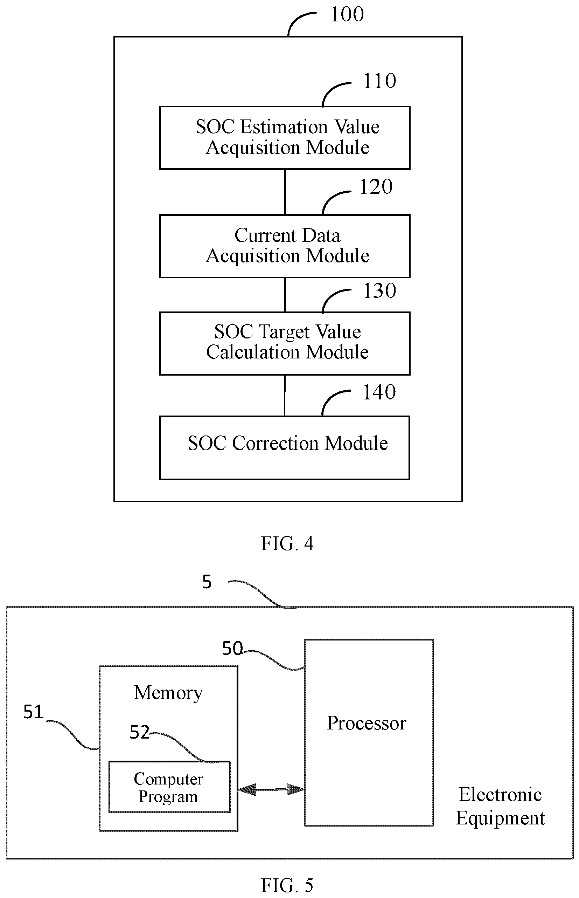

FIG. 4 shows a schematic diagram of a structure of a device 100 for estimation of an SOC of a battery. For the sake of convenience, only the part related to the device is shown, which is described in detail as follows:

As shown in FIG. 4, the device for estimation of the SOC of the battery 100 may include: an SOC estimation value acquisition module 110, a current data acquisition module 120, an SOC target value calculation module 130, and an SOC correction module 140.

The SOC estimation value acquisition module 110 is configured to obtain an SOC estimation value of the battery at a current moment.

The current data acquisition module 120 is configured to obtain an open circuit voltage of the battery at the current moment and a maximum available capacity of the battery at a current temperature.

The SOC target value calculation module 130 is configured to obtain an SOC target value of the battery at the current moment according to the maximum available capacity at the current temperature, the open circuit voltage at the current moment and a capacity-voltage fitting formula. Where, the capacity-voltage fitting formula is a formula obtained by fitting a remaining available capacity and a corresponding open circuit voltage at a preset temperature, and the remaining available capacity is obtained by multiplying a maximum available capacity at the preset temperature and an SOC value at the preset temperature.

The SOC correction module 140 is configured to correct the SOC estimation value of the battery at the current moment using the SOC target value at the current moment.

In one possible implementation, the current data acquisition module 120 includes an open-circuit-voltage calculation unit that is configured to:

obtain a measurement voltage and a measurement current of the battery at the current moment; and
calculate the open circuit voltage of the battery at the current moment according to a formula $U_{ocv} = U_c + i \cdot DCR$, where $U_{ocv}$ represents the open circuit voltage, $U_c$ represents the measurement voltage, i represents the measurement current, and DCR represents the DC internal resistance of the battery.

In one possible implementation, the current data acquisition module 120 includes a maximum-available-capacity calculation unit that is configured to:

obtain the current temperature of the battery; and
look up the maximum available capacity of the battery at the current temperature based on a preset capacity-temperature table.

In a possible implementation, the device for estimation of the SOC of the battery 100 also includes an acquisition module of capacity-voltage fitting formula, which is configured to:

obtain a preset OCV-SOC table, where the preset OCV-SOC table includes multiple open circuit voltage versus SOC value data pairs at the preset temperature;
obtain the maximum available capacity of the battery at the preset temperature;
multiply all SOC values in the multiple open circuit voltage versus SOC value data pairs by the maximum available capacity at the preset temperature respectively, to obtain multiple remaining available capacities at the preset temperature; and
perform polynomial fitting with an independent variable being the remaining available capacity and a dependent variable being the open circuit voltage based on all open circuit voltages in the multiple open circuit voltage versus SOC value data pairs at the preset temperature and the multiple remaining available capacities, to obtain the capacity-voltage fitting formula.

In a possible implementation, the SOC target value calculation module 130 is particularly configured to:
input the maximum available capacity at the current temperature and the open circuit voltage at the current moment into the capacity-voltage fitting formula to obtain the SOC target value of the battery at the current moment.

In a possible implementation, the SOC target value calculation module 130 is particularly configured to:

determine remaining available capacities of the battery at multiple open circuit voltages according to the capacity-voltage fitting formula;
divide each of the remaining available capacities by the maximum available capacity at the current temperature, to obtain SOC values at the current temperature;
determine, based on the SOC values at the current temperature and the corresponding open circuit voltages, the OCV-SOC table at the current temperature; and
look up, in the OCV-SOC table corresponding to the current temperature, the SOC value corresponding to the open circuit voltage at the current moment, and take the SOC value as the SOC target value of the battery at the current moment.

From the above description, it can be seen that the estimation device 100 can obtain the SOC target value at the current temperature through the following operations: first, obtaining an SOC estimation value of the battery at a current moment; then obtaining an open circuit voltage of the battery at the current moment and a maximum available capacity of the battery at a current temperature; and obtaining an SOC target value corresponding to the battery at the current moment according to the maximum available capacity at the current temperature, the open circuit voltage at the current moment and a capacity-voltage fitting formula, where the capacity-voltage fitting formula is a formula obtained by fitting a remaining available capacity and a corresponding open circuit voltage at a preset temperature, and the remaining available capacity is obtained by multiplying a maximum available capacity and an SOC value at the preset temperature; and finally, using the SOC target value at the current moment to correct the SOC estimation value of the battery at the current moment. Through the above operations, the estimation device 100 can obtain the capacity-voltage fitting formula, and based on the capacity-voltage fitting formula, the SOC target values corresponding to open circuit voltages at different temperatures (including the current temperature) are obtained, thereby the accuracy of the battery's SOC correction can be improved.

The present invention also provides a computer program product having a program code. The program code, when executed by a corresponding processor, a controller, a computing device or a piece of electronic equipment, causes the steps of the method for estimating the SOC of the battery above-mentioned to be implemented, such as, steps S101 to S104 shown in FIG. 1. It should be understood by persons skilled in the art that the method and corresponding device may be implemented in various forms of hardware, software, firmware, dedicated processor or a combination thereof. The dedicated processor may be an application specific integrated circuit (ASIC), a reduced instruction set computer (RISC) and/or a field programmable gate array (FPGA). The provided method and device are preferably implemented as a combination of hardware and software. The software is preferably installed on a program storage device as an application. It is typically a machine based on a computer platform with hardware, such as one or more central processing units (CPUs), random access memories (RAMs) and one or more input/output (I/O) interfaces. An operating system is also typically installed on the computer platform. The various processes and functions described here may be part of an application, or part of the process or functions may be executed by an operating system.

FIG. 5 is a schematic diagram of a piece of electronic equipment. As shown in FIG. 5, the electronic equipment 5 provided by the present invention includes: a processor 50, a memory 51, and a computer program 52 stored in the memory 51 and executable by the processor 50. The processor 50 is configured, when executing the computer program 52, to implement the steps of the method for estimating the SOC of the battery in the above-mentioned implementations, such as step S101 to S104 shown in FIG. 1. Alternatively, the processor 50, when executing the computer program 52, enables the functions of each module/unit in the above-mentioned device implementations to be implemented, such as the functions of modules 110 to 140 shown in FIG. 4.

Illustratively, the computer program 52 may be divided into one or more modules/units, these modules/units may be stored in the memory 51 and executed by the processor 50 to complete or implement the solutions provided by the various implementations of the present invention. For example, the computer program 52 may be divided into modules 110 to 140 shown in FIG. 4. These modules/units may be a series of computer program instruction segments capable of performing specific functions, and these instruction segments can describe the execution process of the computer program 52 in the electronic equipment 5.

The electronic equipment 5 may include, but is not limited to, a processor 50 and a memory 51. it will be appreciated by persons skilled in the art that FIG. 5 is only an example of the electronic equipment 5 and does not constitute a limitation on the electronic equipment 5. The electronic equipment 5 may include more or fewer components than shown in the figure, or may include a combination of certain components, or different components. For example, the electronic equipment 5 may also include input and output devices, network access devices, buses, etc.

The processor 50 may be a central processing unit (CPU), or may be other general-purpose processors, a digital signal processor (DSP), an application-specific integrated circuit (ASIC), a field-programmable gate array (FPGA) or other programmable logic devices, discrete gates or transistor logic devices, discrete hardware components, etc. The general-purpose processor may be a microprocessor or any other conventional processor, etc.

The memory 51 may be an internal storage unit of the electronic equipment 5, such as a hard disk or memory of the electronic equipment 5. The memory 51 may also be an external storage device of the electronic equipment 5, such as a plug-in hard disk equipped on the electronic equipment 5, a smart memory card (SMC), a secure digital (SD) card, a flash card, etc. Furthermore, the memory 51 may also include both an internal storage unit of the electronic equipment 5 and an external storage device. The memory 51 is configured to store the computer program 52 and other programs and data required by the electronic equipment 5. The memory 51 may also be configured to temporarily store data that has been output or is to be output.

It can be clearly understood for persons skilled in the art that for the convenience and simplicity of description, only the division of the above-mentioned functional units and modules is discussed as an example. In practical applications, the above function allocation may be completed by different functional units and modules as needed, that is, the internal structure of the device is divided into different functional units or modules to complete all or part of the functions described above. The functional units and modules in the implementation may be integrated into a processing unit, or each unit may exist physically separately, or two or more units may be integrated into one unit. The above-mentioned integrated unit may be implemented in the form of hardware or in the form of a software functional unit. In addition, the specific names of the functional units and modules are only for the convenience of distinguishing each other. For specific working process of the units and modules in the above-mentioned device, references may be made to the corresponding process in the aforementioned method implementations, which will not be repeated here.

The present invention also provides a vehicle, which includes the above-mentioned electronic equipment 5.

In the above implementations, the descriptions of each implementation have their own emphasis. For parts that are not described or recorded in a certain implementation, references may be made to the relevant descriptions of other implementations.

It can be recognized by a person of ordinary skill in the art that the units and algorithm steps of each example described in each implementation disclosed in the present invention may be implemented by electronic hardware, or by a combination of computer software and electronic hardware. Whether these functions are executed in hardware or software depends on the specific application and design constraints of the technical solution. Persons skilled in the art may use different methods to implement the described functions for each specific application.

It should be understood that the disclosed device/electronic equipment and method may be implemented in other ways. For example, the implementation of the device/electronic equipment described above is only schematic. For example, the division of the modules or units is only a logical function division, and other division methods may also be possible in actual implementation. For example, multiple units or components may be combined or integrated into another system, or some features may be ignored or not executed. In addition, the coupling or direct coupling or communication connection between each other shown or discussed may be an indirect coupling or communication connection through some interfaces, devices or units, which may be electrical, mechanical or other forms.

The units described as separate components may or may not be physically separated, and the components shown as units may or may not be physical units. That is, the above components and units may be located in one place, or may be distributed on multiple network units. Some or all of the units may be selected according to actual needs to achieve the purpose of the solution of each implementation.

The integrated module/unit, if implemented in the form of a software functional unit and sold or used as an independent product, may be stored in a computer-readable storage medium. Based on this understanding, in the present invention, all or part of the processes in the above-mentioned various method implementations may be implemented by controlling the relevant hardware through a computer program. The computer program may be stored in a computer-readable storage medium, and the computer program, when executed by a processor, enables the steps of the battery SOC estimation method in each of the above-mentioned implementations to be implemented. Among them, the computer program includes a computer program code, and the computer program code may be in source code form, object code form, executable file or some intermediate form. The computer-readable medium may include: any entity or device capable of carrying the computer program code, a recording medium, a USB flash drive, a mobile hard disk, a magnetic disk, an optical disk, a computer memory, a read-only memory (ROM), a random-access memory (RAM), an electric carrier signal, a telecommunication signal and a software distribution medium, etc. It should be noted that the content contained in the computer-readable medium may be appropriately increased or decreased according to the requirements of legislation and patent practice in the jurisdiction. For example, in some jurisdictions, according to legislation and patent practice, computer-readable media do not include electric carrier signals and telecommunication signals.

## Claims

1. A method for estimating a state of charge, SOC, of a battery, executed by a battery management system, the method comprising:

(S101) obtaining an SOC estimation value of the battery at a current moment;

(S102) obtaining an open circuit voltage, OCV, of the battery at the current moment and a maximum available capacity of the battery at a current temperature;

(S103) obtaining an SOC target value of the battery at the current moment according to the maximum available capacity at the current temperature, the OCV at the current moment and a capacity-voltage fitting formula, and

(S104) correcting the SOC estimation value of the battery at the current moment using the SOC target value at the current moment, **characterized in that**:

the capacity-voltage fitting formula is a formula obtained by fitting a remaining available capacity and a corresponding open circuit voltage at a preset temperature, and the remaining available capacity is obtained by multiplying a maximum available capacity at the preset temperature and an SOC value at the preset temperature.

2. The method for estimating the SOC of the battery according to claim 1, wherein said (S102) obtaining of the OCV of the battery at the current moment comprises:

obtaining a measurement voltage and a measurement current of the battery at the current moment;

calculating the open circuit voltage of the battery at the current moment according to a formula $U_{ocv} = U_c + i \cdot DCR$, wherein $U_{ocv}$ represents the OCV, $U_c$ represents the measurement voltage, $i$ represents the measurement current, and $DCR$ represents a direct current, DC, internal resistance of the battery.

3. The method for estimating the SOC of the battery according to claim 1 or 2, wherein said (S102) obtaining of the maximum available capacity of the battery at the current temperature comprises:

obtaining the current temperature of the battery; and

looking up, based on a preset capacity-temperature table, the maximum available capacity of the battery at the current temperature.

4. The method for estimating the SOC of the battery according to anyone of claims 1-3, wherein a process of obtaining the capacity-voltage fitting formula based on the remaining available capacity and the corresponding OCV at the preset temperature comprises:

obtaining a preset OCV-SOC table, wherein the preset OCV-SOC table comprises multiple OCV versus SOC value data pairs at the preset temperature;

obtaining the maximum available capacity of the battery at the preset temperature;

multiplying all SOC values in the multiple OCV versus SOC value data pairs by the maximum available capacity at the preset temperature respectively, to obtain multiple remaining available capacities at the preset temperature; and

performing polynomial fitting with the remaining available capacity as an independent variable and the OCV as a dependent variable based on all OCVs in the multiple OCV versus SOC value data pairs and the multiple remaining available capacities at the preset temperature, to obtain the capacity-voltage fitting formula.

5. The method for estimating the SOC of the battery according to anyone of claims 1-4, wherein said (S103) obtaining the SOC target value of the battery at the current moment according to the maximum available capacity at the current temperature, the OCV at the current moment and the capacity-voltage fitting formula, comprises:

inputting the maximum available capacity at the current temperature and the OCV at the current moment into the capacity-voltage fitting formula to obtain the SOC target value of the battery at the current moment.

6. The method for estimating the SOC of the battery according to anyone of claims 1-5, wherein said (S103) obtaining the SOC target value of the battery at the current moment according to the maximum available capacity at the current temperature, the OCV at the current moment and the capacity-voltage fitting formula, comprises:

determining remaining available capacities of the battery at multiple open circuit voltages according to the capacity-voltage fitting formula;

dividing each of the remaining available capacities by the maximum available capacity at the current temperature, to obtain SOC values at the current temperature;

determining the OCV-SOC table at the current temperature based on the SOC values at the current temperature and the corresponding open circuit voltages; and

looking up, in the OCV-SOC table at the current temperature, the SOC value corresponding to the open circuit voltage at the current moment, and taking the SOC value as the SOC target value of the battery at the current moment.

7. The method for estimating the SOC of the battery according to anyone of claims 1-6, wherein the preset temperature is 25 degrees Celsius.

8. The method for estimating the SOC of the battery according to anyone of claims 1-7, wherein the capacity-voltage fitting formula is expressed as follows:

$$\begin{cases} Y = F(X) = K_0 \cdot X^0 + K_1 \cdot X^1 + K_2 \cdot X^2 + \cdots + K_n \cdot X^n \\ X = SOC \cdot C_{temp} \end{cases}$$

wherein, Y represents the open circuit voltage, X represents the remaining available capacity of the battery at the preset temperature, $C_{temp}$ represents the maximum available capacity of the battery at the preset temperature, and $K_0 \sim K_n$ represent fitting coefficients.

9. The method for estimating the SOC of the battery according to claim 8, wherein when n = 6, the fitting coefficients are as follows: $K_0$ = 3.329, $K_1$ = 6.16e-05, $K_2$ = 7.498e-09, $K_3$ = - 3.787e-12, $K_4$ = 5.106e-16, $K_5$ = -2.772e-20 and $K_6$ = 5.334e-25.

10. A piece of electronic equipment (5), comprising a memory (51), a processor (50) and a computer program (52) stored in the memory (51) and executable by the processor (50), wherein the processor (50) is configured, when executing the computer program (52), to implement steps of the method for estimating the SOC of the battery according to any one of claims 1 to 9.

11. The electronic equipment (5) according to claim 10, wherein the electronic equipment (5) is a hardware part of a battery management system of a vehicle.

12. A computer-readable storage medium, in which a computer program (52) is stored, wherein the computer program, when executed by a processor (50), causes all steps of the method for estimating the SOC of the battery according to any one of claims 1 to 9 to be implemented.

13. A vehicle, comprising the electronic equipment (5) according to claim 10.


**Patentansprüche**

1. Verfahren zum Schätzen eines Ladezustands, SOC, einer Batterie, ausgeführt durch ein Batteriemanagementsystem, wobei das Verfahren aufweist:

(S101) Erhalten eines SOC-Schätzwerts der Batterie zu einem aktuellen Zeitpunkt;
(S102) Erhalten einer Leerlaufspannung, OCV, der Batterie zu dem aktuellen Zeitpunkt und einer maximalen verfügbaren Kapazität der Batterie bei einer aktuellen Temperatur;
(S103) Erhalten eines SOC-Zielwerts der Batterie zu dem aktuellen Zeitpunkt gemäß der maximalen verfügbaren Kapazität bei der aktuellen Temperatur, der OCV zu dem aktuellen Zeitpunkt und einer Kapazität-Spannungs-Anpassungsformel; und
(S104) Korrigieren des SOC-Schätzwerts der Batterie zu dem aktuellen Zeitpunkt unter Verwendung des SOC-Zielwerts zu dem aktuellen Zeitpunkt, **dadurch gekennzeichnet, dass**
die Kapazität-Spannungs-Anpassungsformel eine Formel ist, die durch Anpassung einer verbleibenden verfügbaren Kapazität und einer entsprechenden Leerlaufspannung bei einer vorgegebenen Temperatur erhalten wird, und die verbleibende verfügbare Kapazität durch Multiplizieren einer maximalen verfügbaren Kapazität bei der vorgegebenen Temperatur und eines SOC-Werts bei der vorgegebenen Temperatur erhalten wird.

2. Verfahren zum Schätzen des SOC der Batterie nach Anspruch 1, wobei das (S102) Erhalten der OCV der Batterie zu dem aktuellen Zeitpunkt aufweist:

Erhalten einer Messspannung und eines Messstroms der Batterie zu dem aktuellen Zeitpunkt;

Berechnen der Leerlaufspannung der Batterie zu dem aktuellen Zeitpunkt gemäß einer Formel $U_{ocv} = U_c + i \cdot DCR$, wobei $U_{ocv}$ die OCV darstellt, $U_c$ die Messspannung darstellt, $i$ den Messstrom darstellt, und DCR einen Gleichstrom-, DC-, Innenwiderstand der Batterie darstellt.

3. Verfahren zum Schätzen des SOC der Batterie nach Anspruch 1 oder 2, wobei das (S102) Erhalten der maximalen verfügbaren Kapazität der Batterie bei der aktuellen Temperatur aufweist:

Erhalten der aktuellen Temperatur der Batterie; und

Nachschlagen, basierend auf einer vorgegebenen Kapazität-Temperatur-Tabelle, der maximalen verfügbaren Kapazität der Batterie bei der aktuellen Temperatur.

4. Verfahren zum Schätzen des SOC der Batterie nach einem der Ansprüche 1-3, wobei ein Vorgang des Erhaltens der Kapazität-Spannungs-Anpassungsformel basierend auf der verbleibenden verfügbaren Kapazität und der entsprechenden OCV bei der vorgegebenen Temperatur aufweist:

Erhalten einer vorgegebenen OCV-SOC-Tabelle, wobei die vorgegebene OCV-SOC-Tabelle mehrere OCV-gegenüber-SOC-Wert-Datenpaare bei der vorgegebenen Temperatur aufweist;

Erhalten der maximalen verfügbaren Kapazität der Batterie bei der vorgegebenen Temperatur;

jeweiliges Multiplizieren aller SOC-Werte in den mehreren OCV-versus-SOC-Wert-Datenpaaren mit der maximalen verfügbaren Kapazität bei der vorgegebenen Temperatur, um mehrere verbleibende verfügbare Kapazitäten bei der vorgegebenen Temperatur zu erhalten; und

Durchführen einer Polynom-Anpassung mit der verbleibenden verfügbaren Kapazität als einer unabhängigen Variablen und der OCV als einer abhängigen Variablen basierend auf allen OCVs in den mehreren OCV-versus-SOC-Wert-Datenpaaren und den mehreren verbleibenden verfügbaren Kapazitäten bei der vorgegebenen Temperatur, um die Kapazität-Spannungs-Anpassungsformel zu erhalten.

5. Verfahren zum Schätzen des SOC der Batterie nach einem der Ansprüche 1-4, wobei das (S103) Erhalten des SOC-Zielwerts der Batterie zu dem aktuellen Zeitpunkt gemäß der maximalen verfügbaren Kapazität bei der aktuellen Temperatur, der OCV zu dem aktuellen Zeitpunkt und der Kapazität-Spannungs-Anpassungsformel aufweist:
Eingeben der maximalen verfügbaren Kapazität bei der aktuellen Temperatur und der OCV zu dem aktuellen Zeitpunkt in die Kapazität-Spannungs-Anpassungsformel, um den SOC-Zielwert der Batterie zu dem aktuellen Zeitpunkt zu erhalten.

6. Verfahren zum Schätzen des SOC der Batterie nach einem der Ansprüche 1-5, wobei das (S103) Erhalten des SOC-Zielwerts der Batterie zu dem aktuellen Zeitpunkt gemäß der maximalen verfügbaren Kapazität bei der aktuellen Temperatur, der OCV zu dem aktuellen Zeitpunkt und der Kapazität-Spannungs-Anpassungsformel aufweist:

Bestimmen verbleibender verfügbarer Kapazitäten der Batterie bei mehreren Leerlaufspannungen gemäß der Kapazität-Spannungs-Anpassungsformel;

Dividieren jeder der verbleibenden verfügbaren Kapazitäten durch die maximale verfügbare Kapazität bei der aktuellen Temperatur, um SOC-Werte bei der aktuellen Temperatur zu erhalten;

Bestimmen der OCV-SOC-Tabelle bei der aktuellen Temperatur basierend auf den SOC-Werten bei der aktuellen Temperatur und den entsprechenden Leerlaufspannungen; und

Nachschlagen, in der OCV-SOC-Tabelle bei der aktuellen Temperatur, des SOC-Werts, der der Leerlaufspannung zu dem aktuellen Zeitpunkt entspricht, und Nehmen des SOC-Werts als den SOC-Zielwert der Batterie zu dem aktuellen Zeitpunkt.

7. Verfahren zum Schätzen des SOC der Batterie nach einem der Ansprüche 1-6, wobei die vorgegebene Temperatur 25 Grad Celsius ist.

8. Verfahren zum Schätzen des SOC der Batterie nach einem der Ansprüche 1-7, wobei die Kapazität-Spannungs-Anpassungsformel wie folgt ausgedrückt ist:

$$\begin{cases} Y = F(X) = K_0 \cdot X^0 + K_1 \cdot X^1 + K_2 \cdot X^2 + \cdots + K_n \cdot X^n \\ X = SOC \cdot C_{temp} \end{cases},$$

wobei Y die Leerlaufspannung darstellt, X die verbleibende verfügbare Kapazität der Batterie bei der vorgegebenen Temperatur darstellt, $C_{temp}$ die maximale verfügbare Kapazität der Batterie bei der vorgegebenen Temperatur darstellt, und $K_0 \sim K_n$ Anpassungskoeffizienten darstellen.

9. Verfahren zum Schätzen des SOC der Batterie nach Anspruch 8, wobei, wenn n = 6, die Anpassungskoeffizienten wie folgt sind: $K_0$ = 3,329, $K_1$ = 6,16e-05, $K_2$ = 7,498e-09, $K_3$ = -3,787e-12, $K_4$ = 5,106e-16, $K_5$ = -2,772e-20 und $K_6$ = 5,334e-25.

10. Teil einer elektronischen Ausrüstung (5), aufweisend einen Speicher (51), einen Prozessor (50) und ein in dem Speicher (51) gespeichertes und durch den Prozessor (50) ausführbares Computerprogramm (52), wobei der Prozessor (50) dazu konfiguriert ist, beim Ausführen des Computerprogramms (52) Schritte des Verfahrens zum Schätzen des SOC der Batterie nach einem der Ansprüche 1 bis 9 zu implementieren.

11. Teil einer elektronischen Ausrüstung (5) nach Anspruch 10, wobei das Teil einer elektronischen Ausrüstung (5) ein Hardwareteil eines Batteriemanagementsystems eines Fahrzeugs ist.

12. Computerlesbares Speichermedium, in welchem ein Computerprogramm (52) gespeichert ist, wobei das Computerprogramm bei Ausführung durch einen Prozessor (50) bewirkt, dass alle Schritte des Verfahrens zum Schätzen des SOC der Batterie nach einem der Ansprüche 1 bis 9 implementiert werden.

13. Fahrzeug, mit dem Teil einer elektronischen Ausrüstung (5) nach Anspruch 10.

**Revendications**

1. Procédé pour estimer un état de charge, SOC, d'une batterie, exécuté par un système de gestion de batterie, le procédé comprenant :

   étape (S101) l'obtention d'une valeur d'estimation de SOC de la batterie à un instant courant ;
   étape (S102) l'obtention d'une tension en circuit ouvert, OCV, de la batterie à l'instant courant et d'une capacité disponible maximum de la batterie à une température courante ;
   étape (S103) l'obtention d'une valeur cible de SOC de la batterie à l'instant courant conformément à la capacité disponible maximum à la température courante, à l'OCV à l'instant courant et à une formule d'ajustement capacité-tension ; et
   étape (S104) la correction de la valeur d'estimation de SOC de la batterie à l'instant courant en utilisant la valeur cible de SOC à l'instant courant,
   **caractérisé en ce que** :
   la formule d'ajustement capacité-tension est une formule qui est obtenue en ajustant une capacité disponible restante et une tension en circuit ouvert correspondante à une température prédéfinie, et la capacité disponible restante est obtenue en multipliant une capacité disponible maximum à la température prédéfinie et une valeur de SOC à la température prédéfinie.

2. Procédé pour estimer le SOC de la batterie selon la revendication 1, dans lequel ladite étape (S102) d'obtention de l'OCV de la batterie à l'instant courant comprend :

   l'obtention d'une tension de mesure et d'un courant de mesure de la batterie à l'instant courant ; et
   le calcul de la tension en circuit ouvert de la batterie à l'instant courant conformément à une formule $U_{OCV} = Uc + i$. DCR, dans laquelle $U_{OCV}$ représente l'OCV, $Uc$ représente la tension de mesure, $i$ représente le courant de mesure et DCR représente une résistance interne en courant continu, DC, de la batterie.

3. Procédé pour estimer le SOC de la batterie selon la revendication 1 ou 2, dans lequel ladite étape (S102) d'obtention de la capacité disponible maximum de la batterie à la température courante comprend :

l'obtention de la température courante de la batterie ; et

la consultation, sur la base d'une table capacité-température prédéfinie, de la capacité disponible maximum de la batterie à la température courante.

4. Procédé pour estimer le SOC de la batterie selon l'une quelconque des revendications 1 à 3, dans lequel un processus d'obtention de la formule d'ajustement capacité-tension sur la base de la capacité disponible restante et de l'OCV correspondante à la température prédéfinie comprend :

l'obtention d'une table OCV-SOC prédéfinie, dans lequel la table OCV-SOC prédéfinie comprend de multiples paires de données de valeur d'OCV versus de valeur de SOC à la température prédéfinie ;

l'obtention de la capacité disponible maximum de la batterie à la température prédéfinie ;

la multiplication de toutes les valeurs de SOC dans les multiples paires de données de valeur d'OCV versus de valeur de SOC respectivement par la capacité disponible maximum à la température prédéfinie, pour obtenir de multiples capacités disponibles restantes à la température prédéfinie ; et

la réalisation d'un ajustement polynomial avec la capacité disponible restante en tant que variable indépendante et avec l'OCV en tant que variable dépendante sur la base de toutes les OCV dans les multiples paires de données de valeur d'OCV versus de valeur de SOC et des multiples capacités disponibles restantes à la température prédéfinie, pour obtenir la formule d'ajustement capacité-tension.

5. Procédé pour estimer le SOC de la batterie selon l'une quelconque des revendications 1 à 4, dans lequel ladite étape (S103) d'obtention de la valeur cible de SOC de la batterie à l'instant courant conformément à la capacité disponible maximum à la température courante, à l'OCV à l'instant courant et à la formule d'ajustement capacité-tension comprend :

l'entrée de la capacité disponible maximum à la température courante et de l'OCV à l'instant courant à l'intérieur de la formule d'ajustement capacité-tension pour obtenir la valeur cible de SOC de la batterie à l'instant courant.

6. Procédé pour estimer le SOC de la batterie selon l'une quelconque des revendications 1 à 5, dans lequel ladite étape (S103) d'obtention de la valeur cible de SOC de la batterie à l'instant courant conformément à la capacité disponible maximum à la température courante, à l'OCV à l'instant courant et à la formule d'ajustement capacité-tension comprend :

la détermination de capacités disponibles restantes de la batterie à de multiples tensions en circuit ouvert conformément à la formule d'ajustement capacité-tension ;

la division de chacune des capacités disponibles restantes par la capacité disponible maximum à la température courante pour obtenir des valeurs de SOC à la température courante ;

la détermination de la table OCV-SOC à la température courante sur la base des valeurs de SOC à la température courante et des tensions en circuit ouvert correspondantes ; et

la consultation, dans la table OCV-SOC à la température courante, de la valeur de SOC qui correspond à la tension en circuit ouvert à l'instant courant et la considération de la valeur de SOC en tant que valeur cible de SOC de la batterie à l'instant courant.

7. Procédé pour estimer le SOC de la batterie selon l'une quelconque des revendications 1 à 6, dans lequel la température prédéfinie est de 25 degrés Celsius.

8. Procédé pour estimer le SOC de la batterie selon l'une quelconque des revendications 1 à 7, dans lequel la formule d'ajustement capacité-tension est exprimée comme suit :

$$\begin{cases} Y = F(X) = K_0 \cdot X^0 + K_1 \cdot X^1 + K_2 \cdot X^2 + \cdots + K_n \cdot X^n \\ X = SOC \cdot C_{temp} \end{cases}$$

où Y représente la tension en circuit ouvert, X représente la capacité disponible restante de la batterie à la température prédéfinie, $C_{temp}$ représente la capacité disponible maximum de la batterie à la température prédéfinie et $K_0 \sim K_n$ représentent des coefficients d'ajustement.

9. Procédé pour estimer le SOC de la batterie selon la revendication 8, dans lequel, lorsque n = 6, les coefficients d'ajustement sont comme suit : $K_0$ = 3,329, $K_1$ = 6,16e-05, $K_2$ = 7,498e-09, $K_3$ = -3,787e-12, $K_4$ = 5,106e-16, $K_5$ = -2,772e-20 et $K_6$ = 5,334e-25.

10. Pièce d'équipement électronique (5) comprenant une mémoire (51), un processeur (50) et un programme informatique (52) stocké dans la mémoire (51) et pouvant être exécuté par le processeur (50), dans lequel le processeur (50) est configuré pour, lors de l'exécution du programme informatique (52), mettre en œuvre des étapes du procédé pour estimer le SOC de la batterie selon l'une quelconque des revendications 1 à 9.

11. Équipement électronique (5) selon la revendication 10, dans lequel l'équipement électronique (5) est une partie matérielle d'un système de gestion de batterie d'un véhicule.

12. Support de stockage lisible par ordinateur dans lequel un programme informatique (52) est stocké, dans lequel le programme informatique, lorsqu'il est exécuté par un processeur (50), provoque la mise en œuvre de toutes les étapes du procédé pour estimer le SOC de la batterie selon l'une quelconque des revendications 1 à 9.

13. Véhicule, comprenant l'équipement électronique (5) selon la revendication 10.

| S101 |
| --- |
| Obtaining an SOC estimation value of the battery at a current moment |

| S102 |
| --- |
| Obtaining an open circuit voltage of the battery at the current moment and a maximum available capacity of the battery at a current temperature |

| S103 |
| --- |
| Obtaining an SOC target value of the battery at the current moment according to the maximum available capacity at the current temperature, the open circuit voltage at the current moment and a capacity-voltage fitting formula; where the capacity-voltage fitting formula is a formula obtained by fitting a remaining available capacity and a corresponding open circuit voltage at a preset temperature, and the remaining available capacity is obtained by multiplying a maximum available capacity and an SOC value at the preset temperature |

| S104 |
| --- |
| Correcting the SOC estimation value of the battery at the current moment using the SOC target value at the current moment |

FIG. 1

FIG. 2

FIG. 3

FIG. 4

FIG. 5

**EP 4 455 697 B1**